# DEMANDE DE BREVET EUROPEEN

(11) **EP 3 592 124 A1**
(43) Date de publication de la demande: **08.01.2020**
(21) Numéro de dépôt: 19183120.5
(22) Date de dépôt: 28.06.2019
(51) Int. Cl.: H05K 7/20, G09F 9/302, G09F 9/33

(54) **DISPOSITIF DE VENTILATION D'UN PANNEAU D'AFFICHAGE DIGITAL ET PANNEAU ASSOCIE**

(30) Priorité: 06.07.2018 FR 1856264
(71) Demandeur: Prismaflex International, 69610 Haute-Rivoire (FR)
(72) Inventeur: DULIEU, William, 42210 MONTROND LES BAINS (FR)
(74) Mandataire: Cabinet Laurent & Charras

(57) **Abrégé**

L'invention concerne un dispositif de ventilation (10) comportant :
- un montant (11) destiné à former un montant interne d'un panneau d'affichage digital, une face avant (12) comportant des moyens de fixation de modules LEDs disposés de part et d'autre dudit montant ;
- au moins un ventilateur (29) destiné à générer un flux d'air pour refroidir des modules LEDs ;
- une cavité de circulation d'air ménagée dans la longueur dudit montant entre ladite face avant (12) et une face arrière (23), ladite cavité étant délimitée latéralement par des parois latérales ;
- au moins un ventilateur (29) monté sur ladite face arrière au niveau d'une ouverture d'arrivée d'air (27) débouchant dans ladite cavité de circulation d'air ; et
- des ouvertures d'extraction d'air (28) ménagées sur lesdites parois latérales configurées pour guider l'air contenu dans ladite cavité sur une face arrière des modules LEDs.

## Description

### DOMAINE TECHNIQUE

L'invention se rattache au domaine des panneaux d'affichage, et plus précisément des panneaux d'affichages digitaux à diodes électroluminescentes (LEDs).

L'invention vise plus particulièrement à améliorer le refroidissement de ces panneaux d'affichage digital.

### ART ANTERIEUR

De façon générale, les panneaux d'affichages digitaux sont appréciés pour la possibilité qu'ils offrent de permettre un changement quasi infini des images ou messages à afficher. Ces panneaux d'affichages digitaux comportent une pluralité de diodes électroluminescentes, disposées de façon matricielle, et aptes à être éclairées individuellement en fonction de l'affichage souhaité. Ces LEDs sont intégrées sous la forme de modules, renfermant chacun quelques centaines de LEDs, tel que décrit dans le document US 5 949 581.

Pour former un panneau d'affichage digital, il est connu de monter plusieurs modules LEDs sur une structure porteuse afin de former une surface d'affichage. Ainsi, les dimensions de la surface d'affichage sont des multiples des dimensions d'un module LEDs. Par exemple, pour un module de longueur 40cm et de hauteur 50cm, la longueur de la surface d'affichage est un multiple de 40cm alors que la hauteur de la surface d'affichage est un multiple de 50cm.

Tel que décrit dans le document US 2011/072697, la structure porteuse peut comporter des poutres externes et des montants internes sur lesquels les modules LEDs sont fixés.

Le refroidissement des modules LEDs est classiquement assuré par des ventilateurs montés sur la poutre horizontale inférieure. Les ventilateurs sont régulièrement répartis entre deux colonnes de modules LEDs et ils sont montés sur des ouvertures de la poutre horizontale inférieure de sorte à capter l'air extérieur pour le ventiler à l'intérieur du panneau sur la face arrière des modules des LEDs.

Cependant, ce type de refroidissement n'est pas homogène sur l'ensemble des modules LEDs car, même en réglant de manière optimum la vitesse de rotation des ventilateurs, l'air est propulsé trop fortement dans la partie inférieure du panneau pour refroidir efficacement les premiers modules et l'air ralentit progressivement dans la hauteur du panneau de sorte que l'air atteignant la partie supérieure du panneau n'a pas une vélocité suffisante pour refroidir efficacement les derniers modules LEDs.

Pour résoudre ce problème et refroidir de manière homogène les modules LEDs d'un panneau d'affichage digital, il est possible de positionner un ventilateur sur chaque face arrière de chaque module LEDs. Cependant, cette solution est très énergivore car elle requiert un nombre de ventilateurs égal au nombre de modules LEDs.

En outre, le refroidissement n'est pas très efficace au regard de l'énergie nécessaire car le flux d'air généré par chaque ventilateur est perpendiculaire à la face des modules LEDs. Or, les dissipateurs thermiques associés aux modules LEDs s'étendent également perpendiculairement à la face des modules LEDs. Ainsi, la génération d'un flux d'air perpendiculaire à la face des modules LEDs ne permet pas aux dissipateurs thermiques de fonctionner efficacement.

Lorsqu'un module LEDs chauffe trop, il est souvent nécessaire de réduire la luminosité des diodes électroluminescentes pour éviter de les endommager. Pour que le panneau d'affichage digital présente une image cohérente, l'ensemble des luminosités des modules LEDs est ainsi calé sur la luminosité maximale imposée par le module LEDs qui est le plus chaud. Il s'ensuit que le refroidissement des modules LEDs les plus chauds permet d'augmenter la luminosité globale de l'image du panneau d'affichage digital.

Le problème technique de l'invention consiste à refroidir de manière homogène les modules LEDs d'un panneau d'affichage digital tout en limitant le nombre de ventilateurs.

### EXPOSE DE L'INVENTION

Pour répondre à ce problème technique, l'invention propose d'utiliser un montant interne au panneau pour former un dispositif de ventilation et ventiler les modules LEDs montés de part et d'autre du montant. Pour ce faire, ce montant interne comporte une cavité de circulation d'air alimentée en air par au moins un ventilateur. L'air est extrait de cette cavité de circulation d'air au niveau d'ouvertures d'extraction d'air ménagées sur des parois latérales du montant de sorte à ventiler la face arrière des modules LEDs.

A cet effet, selon un premier aspect, l'invention concerne un dispositif de ventilation d'un panneau d'affichage digital, ledit dispositif comportant :
- un montant destiné à former un montant interne d'un panneau d'affichage digital, une face avant dudit montant étant apte à recevoir des modules LEDs disposés de part et d'autre dudit montant ; et
- au moins un ventilateur destiné à générer un flux d'air pour refroidir des modules LEDs.

L'invention se caractérise en ce que ledit dispositif de ventilation comporte :
- une cavité de circulation d'air ménagée dans la longueur dudit montant entre ladite face avant et une face arrière dudit montant, opposée à ladite face avant, ladite cavité de circulation d'air étant délimitée latéralement par des parois latérales dudit montant ;
- au moins un ventilateur monté sur ladite face arrière au niveau d'une ouverture d'arrivée d'air dudit montant, ladite ouverture d'arrivée d'air débouchant dans ladite cavité de circulation d'air ; et
- des ouvertures d'extraction d'air ménagées sur lesdites parois latérales dudit montant et configurées pour guider l'air contenu dans ladite cavité de circulation d'air sur une face arrière des modules LEDs.

Contrairement à la poutre inférieure qui supporte des modules LEDs uniquement sur son côté supérieur, l'invention propose de positionner au moins un ventilateur sur au moins un montant horizontal et/ou vertical interne au panneau d'affichage digital, c'est-à-dire sur au moins un montant disposé entre plusieurs modules LEDs juxtaposés. L'air est injecté dans le montant interne au moyen d'au moins un ventilateur monté sur une ouverture d'arrivée d'air.

L'air est extrait du montant interne par des ouvertures d'extraction d'air ménagées sur des parois latérales du montant. Ainsi, l'air est projeté dans une direction parrallèle à la face des modules LEDs et perpendiculaire à la direction d'extension des dissipateurs thermiques. Ce faisant, l'air extrait du montant interne refroidit efficacement les dissipateurs thermiques des modules LEDs. De préférence, le montant interne comporte une ouverture d'extraction d'air disposée en regard de chaque module LEDs. Ainsi, le refroidissement des modules LEDs est également amélioré car l'air est projeté au plus près de chaque module LEDs.

La luminosité d'une image diffusée sur un panneau d'affichage digital étant généralement réglée sur la luminosité du module LEDs le plus chaud, l'amélioration de l'homogénéité des températures des modules LEDs permet d'améliorer la luminosité de l'image diffusée sur le panneau d'affichage digital.

De plus, les modules LEDs présentent généralement une épaisseur s'étendant dans l'épaisseur des montants lorsque les modules LEDs sont montés sur la structure porteuse du panneau d'affichage digital. Dans cette épaisseur s'étendent les dissipateurs thermiques et les éléments de commande des LEDs du module, tels que les cartes électroniques. Pour éviter aux ouvertures d'extraction d'air d'être partiellement obturées par les éléments des modules LEDs s'étendant dans l'épaisseur des montants, ledit montant comporte un élévateur s'étendant dans la longueur dudit montant entre ladite face avant et une paroi de fond de ladite cavité de circulation d'air.

Ce mode de réalisation permet d'élever la hauteur de projection de l'air depuis les parois latérales du montant de sorte à améliorer le refroidissement des cartes électroniques et des dissipateurs thermiques des modules LEDs.

Selon un mode de réalisation, ladite paroi de fond de ladite cavité de circulation d'air présente une largeur inférieure à une largeur de ladite face arrière de sorte que lesdites parois latérales présentent une inclinaison en direction des modules LEDs.

Ce mode de réalisation permet d'orienter efficacement l'air projeté par le dispositif de ventilation sur les modules LEDs montés sur le montant. Ainsi, ce montant interne formant le dispositif de ventilation refroidit efficacement les seuls modules LEDs montés sur celui-ci et d'autres montants sont aménagés sous la forme de dispositifs de ventilation pour refroidir les autres modules LEDs. Il s'ensuit que l'homogénéité du refroidissement des modules LEDs est améliorée par la redondance des dispositifs de refroidisement d'un panneau d'affichage digital.

De préférence, les modules LEDs sont refroidis sur chacun de leurs côtés latéraux par un dispositif de ventilation.

Selon un mode de réalisation, une somme des surfaces des ouvertures d'extraction d'air associées à un ventilateur est inférieure à une surface de ladite ouverture d'arrivée d'air. Ce mode de réalisation permet de réaliser un effet Venturi en sortie des ouvertures d'extraction d'air, réduisant ainsi la vitesse de rotation nécessaire du ventilateur pour obtenir une vitesse d'extraction d'air recherchée en sortie des ouvertures d'extraction d'air.

Selon un mode de réalisation, ledit au moins un ventilateur, ladite ouverture d'arrivée d'air, et lesdites ouvertures d'extraction d'air sont configurés de sorte que la vitesse d'extraction d'air en sortie des ouvertures d'extraction d'air soit au minimum de 3.5 m/s. Ce mode de réalisation permet d'obtenir un refroidissement efficace des modules LEDs.

Selon un mode de réalisation, ledit montant comporte plusieurs ventilateurs régulièrement disposés entre quatres modules LEDs. Ce mode de réalisation permet d'obtenir un refroidissement efficace des modules LEDs.

Selon un mode de réalisation, ledit montant comportant au moins un ventilateur est alimenté électriquement par un boîtier de dérivation disposé en haut ou en bas dudit montant. Ce mode de réalisation permet d'alimenter chaque montant formant un dispositif de ventilation de manière indépendante de sorte qu'un disfonctionnement dans un des boîtiers de dérivation n'entraine pas l'arrêt de l'ensemble des dispositifs de ventilation d'un panneau d'affichage digital.

Selon un mode de réalisation, ledit montant correspond à une poutre porteuse verticale ou horizontale dudit panneau. Ce mode de réalisation permet au dispositif de ventilation d'assurer une partie de la structure porteuse des modules LEDs.

Selon un second aspect, l'invention concerne un panneau d'affichage digital comportant :
- une pluralité de modules LEDs, chaque module LEDs comportant un réseau de diodes électroluminescentes disposées en lignes et en colonnes avec un pas sensiblement constant ; et
- une structure porteuse formée par des poutres et des montants internes destinés à supporter les modules LEDs ;
- au moins un montant interne formant un dispositif de ventilation selon le premier aspect de l'invention.

Selon un mode de réalisation, une poutre inférieure comporte des ouvertures et des ventilateurs aptes à capter l'air extérieur au panneau pour le ventiler à l'intérieur du panneau. Ce mode de réalisation permet d'utiliser les ventilateurs disposés sur le montant inférieur pour capter l'air extérieur et le ventiler dans le panneau alors que les montants internes réutilisent l'air contenu dans le panneau pour ventiler ponctuellement les modules LEDs.

### DESCRIPTION SOMMAIRE DES FIGURES

La manière de réaliser l'invention ainsi que les avantages qui en découlent, ressortiront bien du mode de réalisation qui suit, donné à titre indicatif mais non limitatif, à l'appui des figures annexées dans lesquelles les figures 1 à 7 représentent :
- Figure 1 : une vue en perspective d'un dispositif de ventilation selon un premier mode de réalisation de l'invention ;
- Figure 2 : une représentation schématique en coupe du montant du dispositif de ventilation de la figure 1 ;
- Figure 3 : une vue en perspective de la face arrière d'un panneau d'affichage digital intégrant le dispositif de ventilation de la figure 1 ;
- Figure 4 : une vue en perspective de la face arrière d'un panneau d'affichage digital intégrant le dispositif de ventilation selon un second mode de réalisation de l'invention ;
- Figure 5 : un agrandissement d'une partie de la figure 4 ;
- Figure 6 : une représentation schématique de face des températures des modules LEDs d'un panneau sans l'invention ; et
- Figure 7 : une représentation schématique de face des températures des modules LEDs d'un panneau intégrant un dispositif de ventilation de l'invention.

### DESCRIPTION DETAILLEE DE L'INVENTION

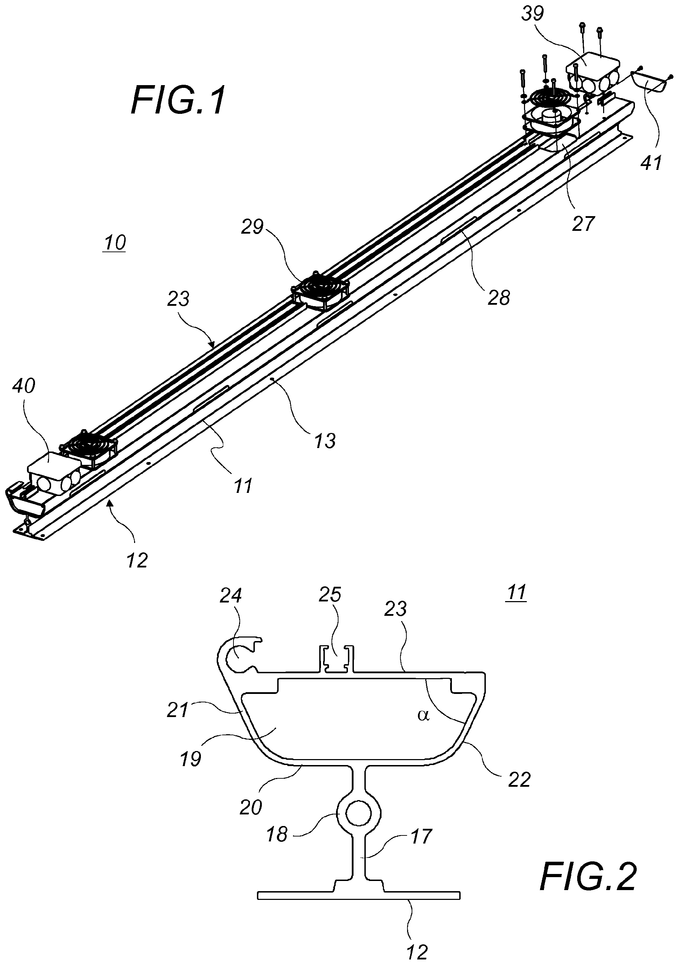

La Figure 1 illustre un dispositif de ventilation **10** formé sur un montant interne **11** d'un panneau d'affichage digital **16a**. Le montant interne **11** présente une face avant **12** sensiblement plane. Six alésages **13** sont régulièrement répartis dans la longueur de cette face avant **12** et de chaque côté de cette face avant **12**. Ces alésages **13** permettent de fixer des barreaux horizontaux **14** lorsque le montant interne **11** forme la structure porteuse **15a** d'un panneau d'affichage digital **16a**.

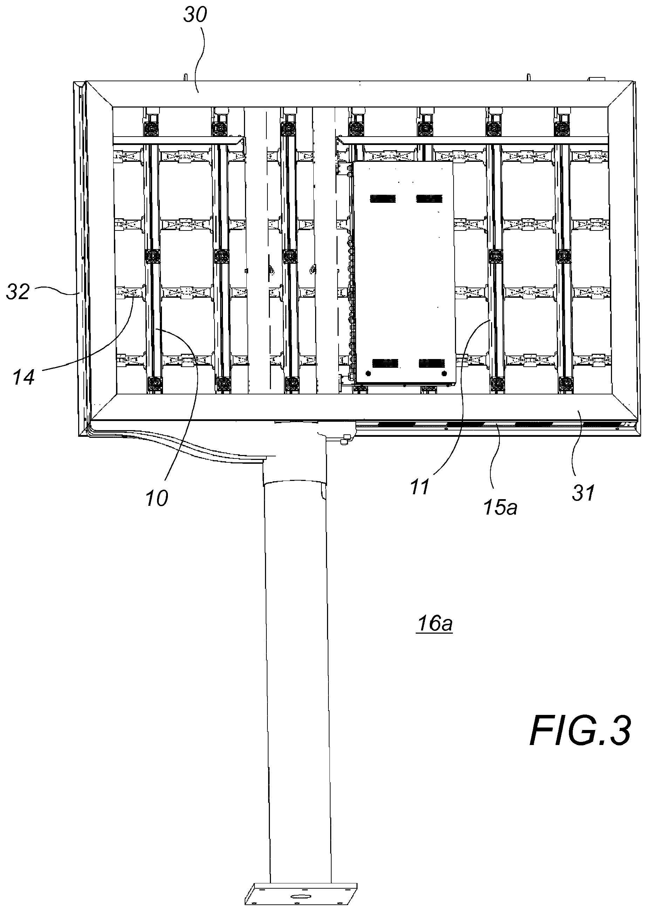

Tel qu'illustré sur la figure 3, lorsque le montant interne **11** est intégré dans un panneau d'affichage digital **16a**, il est fixé aux niveaux de ses extrémités supérieure et inférieure respectivement sur une poutre supérieure **30** et une poutre inférieure **31**. Ces poutres **30**, **31** sont reliées entre elles par des poutres latérales **32**. Les modules LEDs sont supportés par ces poutres **30-32**, les montants internes **11** et les barreaux horizontaux **14** qui forment un maillage régulier sur la surface d'affichage du panneau **16**. Il s'ensuit que chaque module LEDs est fixé sur au moins un côté sur une face avant **12** d'un montant interne **11**. La fixation des modules LEDs peut être réalisée par des ergots ou des crochets montés sur le module LEDs et aptes à coopérer avec une face interne de la plaque formant la face avant **12**.

Tel qu'illustré sur la figure 2, chaque montant interne **11** s'étend dans l'épaisseur du panneau **16** avec un élévateur **17**. Cet élévateur **17** s'étend sensiblement perpendiculairement à la face avant **12** du montant **11** et se présente sous la forme d'un pied avec un élément de renfort circulaire **18** disposé sensiblement au milieu de la hauteur du pied.

Au-dessus de l'élévateur **17**, le montant **11** présente une cavité de circulation d'air **19**. Cette cavité de circulation d'air **19** est composée d'une paroi de fond **20**, de deux parois latérales **21** et **22** et d'une face arrière **23**. La face arrière **23** présente une largeur sensiblement équivalente à la largeur de la face avant **12**. La paroi de fond **20** présente une largeur inférieure à la largeur de la face arrière **23** et les parois latérales **21** et **22** s'étendent en biais entre la face arrière **23** et la paroi de fond **20**. L'angle **α** entre la face arrière **23** et chaque paroi latérale **21**, **22** peut être compris entre 45 et 70°.

La face arrière **23** est également pourvue de deux goulottes **24**, **25** destinées à acheminer les fils électriques. La cavité de circulation d'air **19** est pourvue de trois ouvertures d'arrivée d'air **27**. Ces ouvertures d'arrivée d'air **27** sont régulièrement réparties le long de la face arrière **23** du montant **11** de sorte que l'ouverture supérieure soit disposée entre deux modules LEDs de la ligne supérieure du panneau d'affichage digital **16a** et que l'ouverture inférieure soit disposée entre deux modules LEDs de la ligne inférieure du panneau d'affichage digital **16a**. La troisième ouverture est disposée entre les ouvertures supérieure et inférieure sensiblement au milieu de la longueur du montant **11**.

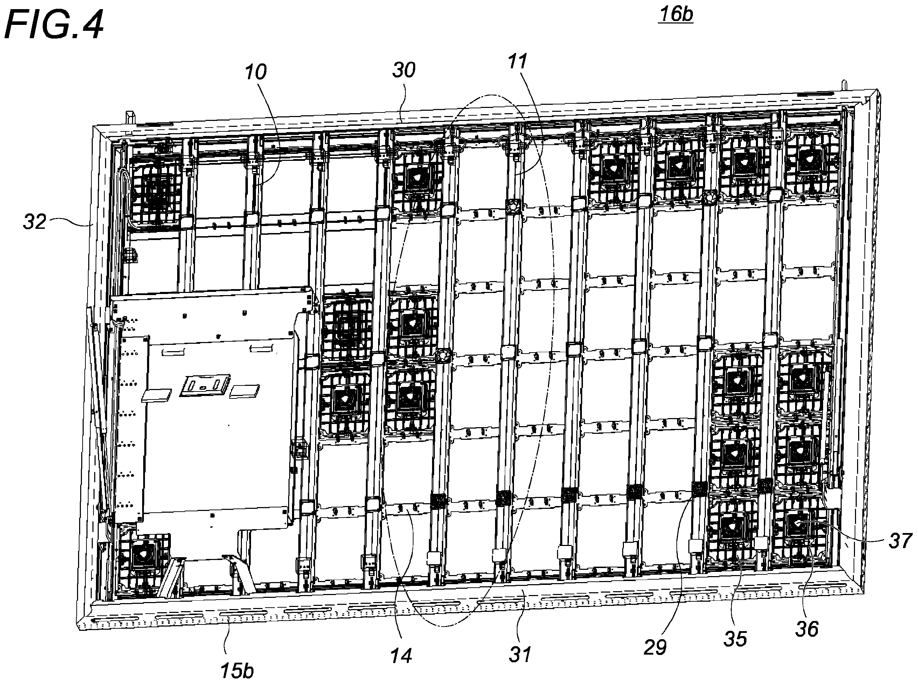

Le nombre de modules LEDs alimentés par ces ouvertures d'arrivée d'air **27** peut varier sans changer l'invention. En effet, tel qu'illustré sur la figure 4 pour un second exemple de panneau **16b** avec une structure porteuse **15b** distincte, une ouverture d'arrivée d'air alimente quatre modules LEDs disposés de part et d'autre de chaque montant vertical **11.**

Une ouverture d'arrivée d'air **27** peut également être configurée pour ventiler six ou huit modules LEDs. La ventilation des modules LEDs est assurée par des ouvertures d'extraction d'air **28** ménagées sur les parois latérales **21**, **22** du montant **11**. Ces ouvertures d'extraction d'air **28** se présentent sous la forme de trous oblongs dont la longueur s'étend suivant la longueur du montant **11** et en regard du côté des modules LEDs.

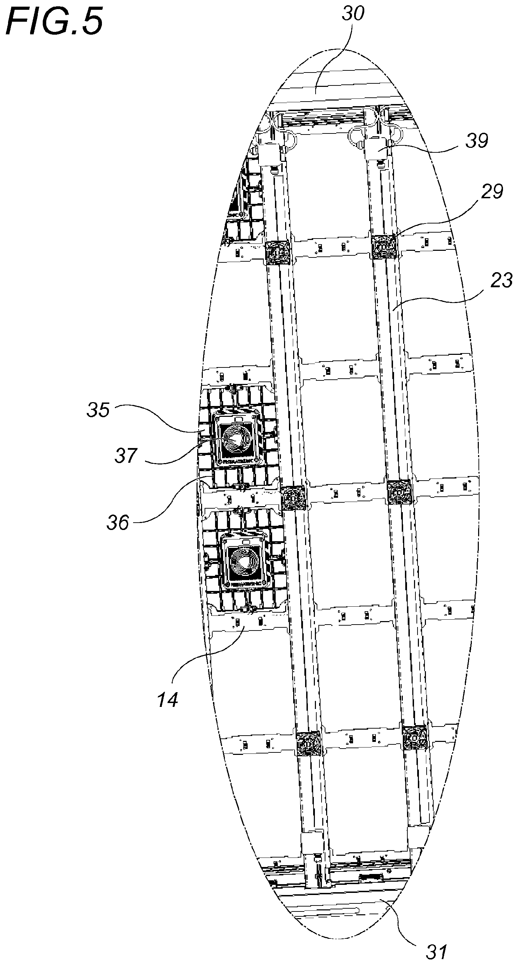

Plus précisément, lorsque des modules LEDs **35** sont montés sur une structure porteuse **15b** tel qu'illustré sur les figures 4 et 5, chaque module LEDs **35** comporte des dissipateurs thermiques **36** et un boîtier de carte électronique **37** qui s'étendent dans l'épaisseur du panneau d'affichage digital **16b**.

Les ouvertures d'extraction d'air **28** sont placées de telle sorte à ventiler les dissipateurs thermiques **36** et le boîtier de la carte électronique **37** perpendiculairement à leurs élévations, c'est-à-dire en direction des bords latéraux du panneau d'affichage digital **16b**.

Les différentes ouvertures d'extraction d'air **28** alimentées par une ouverture d'arrivée d'air **27** présentent préférentiellement une surface d'extraction d'air inférieure à la surface de l'ouverture d'arrivée d'air **27** correspondante de sorte à obtenir un effet Venturi entre l'air injecté dans le montant **11** et l'air extrait par les ouvertures d'extraction d'air **28**. Ainsi, la vitesse de l'air injecté dans le montant **11** est démultipliée en sortie pour améliorer l'effet de ventilation des modules LEDs. La vitesse de l'air en entrée du montant **11** est conditionnée par des ventilateurs **29** montés sur les ouvertures d'arrivée d'air **27**. Pour ce faire, les ouvertures d'arrivée d'air **27** présentent classiquement une forme parallélépipédique correspondante à la forme des ventilateurs **27** de sorte que l'air en sortie des ventilateurs **27** pénètre directement dans le montant **11.**

Pour obtenir un refroidissement efficace des modules LEDs, il a été constaté qu'il était pertinent d'obtenir une vitesse d'extraction d'air en sortie de chaque ouverture d'extraction d'air **28** du montant **11** comprise entre 3,5 et 4,5 m/s. Cette vitesse d'extraction d'air peut être mesurée par un anémomètre ou un débitmètre, par exemple par le produit Extech HD 300 de la société Flir®. Pour obtenir cette vitesse d'extraction d'air, il suffit de régler la vitesse des ventilateurs **29** et la taille des ouvertures d'extraction d'air **28** en fonction du nombre d'ouvertures d'extraction d'air **28** alimentées par chaque ventilateur **29**.

L'alimentation électrique des différents ventilateurs **29** montés sur le montant **11** est préférentiellement assurée par un boîtier de dérivation **39** et un dispositif de régulation **40** apte à augmenter ou réduire la vitesse des ventilateurs **29** selon les besoins de refroidissement. En effet, de nouveaux modules LEDs permettent de renseigner sur la température des LEDs et du circuit électronique au cours du temps si bien qu'il est possible d'adapter les besoins de ventilation pour obtenir une température homogène dans le panneau d'affichage digital. Pour ce faire, les ventilateurs **29** d'un montant **11** peuvent être commandés simultanément ou indépendamment en fonction des besoins de ventilation par le biais de l'organe de régulation **40**.

Pour que l'air injecté par les ventilateurs **29** dans le montant **11** reste contenu dans ce montant **11** avant son extraction par les ouvertures d'extraction d'air **28**, des bouchons **41** sont préférentiellement ménagés aux extrémités inférieure et supérieure du montant **11**.

L'invention est décrite en référence à un montant vertical **11**. En variante, invention peut également être mise en oeuvre avec des montants horizontaux reliés par des barreaux verticaux.

Cet assemblage de montants **11** et de barreaux **14** pour former une structure porteuse **15a**, **15b** est particulièrement avantageux car il permet de réaliser un panneau d'affichage digital sur mesure en fonction de dimensions recherchées.

Pour ce faire, les montants **11** sont découpés en une dimension multiple de nombre de modules LEDs recherché. Par exemple, s'il est recherché un panneau d'affichage digital avec six modules LEDs en hauteur et cinq modules LEDs en largeur, des poutres sont découpées pour réaliser le cadre de la structure porteuse. Des montants verticaux **11** sont ensuite découpés pour former les quatre montants internes et ils sont équipés de ventilateurs **29** pour former des dispositifs de refroidissement.

La structure porteuse est ensuite réalisée, en atelier ou directement sur le site de montage, en fixant les montants internes sur le cadre et les barreaux horizontaux sur les montants et les poutres latérales. Pour finir, les modules LEDs sont fixés sur la structure porteuse et le câblage électrique est réalisé. De préférence, les montants **11** sont réalisés par des profilés aluminium pour répondre aux besoins de légèreté et de résistance tout en permettant une réalisation et une découpe simple.

L'invention permet ainsi de capter l'air à l'intérieur d'un panneau d'affichage digital pour ventiler de manière homogène des modules LEDs. En outre, l'air peut également être conduit à l'intérieur du panneau par des ventilateurs disposés sur la poutre inférieure et aptes à capter l'air à l'extérieur du panneau.

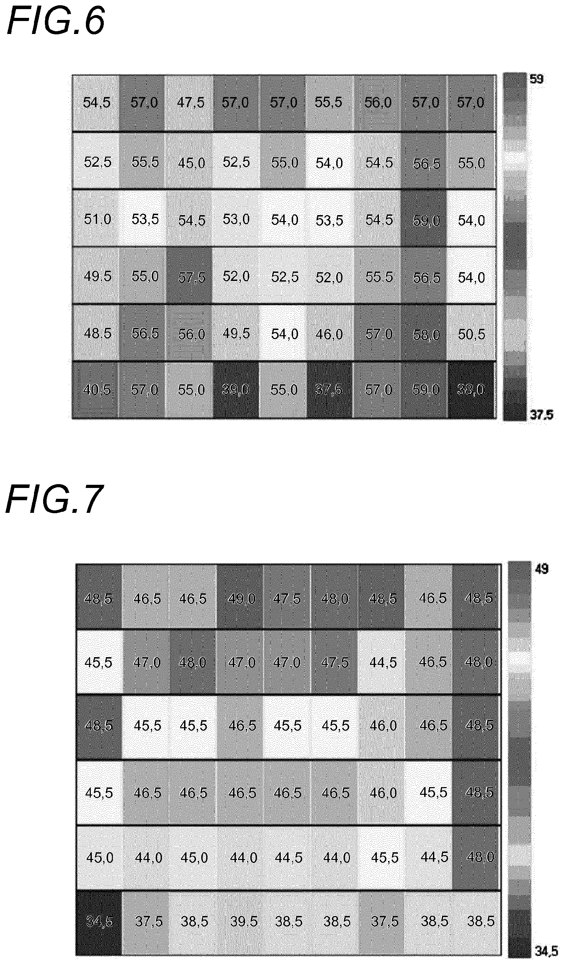

Des tests ont été réalisés pour modéliser l'impact de l'invention entre deux panneaux comportant une surface d'affichage de 9 m² et diffusant une image blanche luminosité de 4500 cd/m². Tel qu'illustré sur la figure 6, les températures des différents modules LEDs d'un panneau de l'état de la technique sont comprises entre 37,5 °C et 59 °C. Dans les mêmes conditions de test, tel qu'illustré sur la figure 7, le même panneau intégrant un dispositif de ventilation de l'invention présente des températures variant entre 34,5 °C et 49 °C pour les modules LEDs. Il s'ensuit que l'invention permet effectivement de limiter l'hétérogénéité des températures des modules LEDs. Ainsi, il est possible d'augmenter la luminosité du panneau d'affichage digital sans risquer de détériorer un module LEDs par rapport aux autres.

## Revendications

1. Dispositif de ventilation (10) d'un panneau d'affichage digital (16a, 16b), ledit dispositif comportant :
- un montant (11) destiné à former un montant interne d'un panneau d'affichage digital (16a, 16b), une face avant (12) dudit montant (11) étant apte à recevoir des modules LEDs disposés de part et d'autre dudit montant (11) ; et
- au moins un ventilateur (29) destiné à générer un flux d'air pour refroidir des modules LEDs ;
***caractérisé en ce que*** ledit dispositif de ventilation (10) comporte :
- une cavité de circulation d'air (19) ménagée dans la longueur dudit montant (11) entre ladite face avant (12) et une face arrière (23) dudit montant, opposée à ladite face avant (12), ladite cavité de circulation d'air (19) étant délimitée latéralement par des parois latérales (21, 22) dudit montant (11) ;
- au moins un ventilateur (29) monté sur ladite face arrière (23) au niveau d'une ouverture d'arrivée d'air (27) dudit montant (11), ladite ouverture d'arrivée d'air (27) débouchant dans ladite cavité de circulation d'air (19) ; et
- des ouvertures d'extraction d'air (28) ménagées sur lesdites parois latérales (21, 22) dudit montant (11) et configurées pour guider l'air contenu dans ladite cavité de circulation d'air (19) sur une face arrière des modules LEDs.

2. Dispositif de ventilation selon la revendication 1, ***dans lequel*** ledit montant (11) comporte un élévateur (17) s'étendant dans la longueur dudit montant (11) entre ladite face avant (12) et une paroi de fond (20) de ladite cavité de circulation d'air (27).

3. Dispositif de ventilation selon la revendication 2, ***dans lequel*** ladite paroi de fond (20) de ladite cavité de circulation d'air (19) présente une largeur inférieure à une largeur de ladite face arrière (23) de sorte que lesdites parois latérales (21, 22) présentent une inclinaison en direction des modules LEDs.

4. Dispositif de ventilation selon l'une des revendications 1 à 3, ***dans lequel*** une somme des surfaces des ouvertures d'extraction d'air (28) associées à un ventilateur (29) est inférieure à une surface de ladite ouverture d'arrivée d'air (27).

5. Dispositif de ventilation selon l'une des revendications 1 à 4, ***dans lequel*** ledit au moins un ventilateur (29), ladite ouverture d'arrivée d'air (27), et lesdites ouvertures d'extraction d'air (28) sont configurées de sorte que la vitesse d'extraction d'air en sortie des ouvertures d'extraction d'air (28) soit au minimum de 3.5 m/s.

6. Dispositif de ventilation selon l'une des revendications 1 à 5, ***dans lequel*** ledit montant (11) comporte plusieurs ventilateurs (29) régulièrement disposés entre quatre modules LEDs.

7. Dispositif de ventilation selon l'une des revendications 1 à 6, ***dans lequel*** ledit au moins un ventilateur (29) est alimenté électriquement par un boîtier de dérivation (39) disposé en haut ou en bas dudit montant (11).

8. Dispositif de ventilation selon l'une des revendications 1 à 7, ***dans lequel*** ledit montant (11) correspond à une poutre porteuse verticale ou horizontale dudit panneau.

9. Panneau d'affichage digital (16a, 16b) comportant :
- une pluralité de modules LEDs, chaque module LEDs comportant un réseau de diodes électroluminscentes disposées en lignes et en colonnes avec un pas sensiblement constant ; et
- une structure porteuse (15a, 15b) formée par des poutres (30-32) et des montants internes (11) destinés à supporter les modules LEDs ;
***caractérisé en ce que*** au moins un montant interne (11) forme un dispositif de ventilation (10) selon l'une des revendication 1 à 8.

10. Panneau d'affichage digital selon la revendication 9, ***dans lequel*** une poutre inférieure (31) comporte des ouvertures et des ventilateurs aptes à capter l'air extérieur au panneau pour le ventiler à l'intérieur du panneau.
